# EUROPÄISCHE PATENTSCHRIFT

(11) **EP 0 542 148 B1**
(45) Veröffentlichungstag und Bekanntmachung des Hinweises auf die Patenterteilung: **22.01.1997**
(21) Anmeldenummer: 92119044.3
(22) Anmeldetag: 06.11.1992
(51) Int. Cl.: H01L 31/0224

(54) **Verfahren zum Erzeugen feiner Elektrodenstruckturen**
Process for forming fine electrode structures
Procédé pour former des structures d'électrodes fines

(30) Priorität: 11.11.1991 DE 4137044
(43) Veröffentlichungstag der Anmeldung: 19.05.1993
(73) Patentinhaber: SIEMENS SOLAR GmbH, 80807 München (DE)
(72) Erfinder: Holdermann, Konstantin, W-8875 Offingen (DE)
(74) Vertreter: Zangs, Rainer E., Dipl.-Ing.

(56) Entgegenhaltungen:
- WO-A-89/12321
- GB-A- 1 258 856
- ELECTRONICS Bd. 53, Nr. 20, 11. September 1980, NEW YORK US Seiten 40 - 41 J. LYMAN 'Thick film, plating cut cost of laying down solar cell contacts and conductors'
- METAL FINISHING Bd. 87, Nr. 6, Juni 1989, HACKENSACK, NJ US Seiten 115 - 117 S. SRIVEERARAGHAVAN ET AL. 'Silver electrodeposition from thiosulfate solutions'
- DATABASE WPIL Week 7935, Derwent Publications Ltd., London, GB; AN 79-64474B & SU-A-633 938
- NINETEENTH IEEE PHOTOVOLTAIC SPECIALISTS CONFERENCE, New Orleans, Louisana, 4. - 8. Mai 1987, Seiten 70-75, IEEE, New York, US, S.P. TOBIN et al.: "Advanced metallization for highly efficient solar cells"

## Beschreibung

Eine weit verbreitete und wirtschaftlich durchführbare Methode zur Erzeugung von dünnen Leiterbahnen und Elektrodenstrukturen auf halbleitenden und isolierenden Substraten ist die Dickfilmmetallisierung. Ausgangsmaterial für die Erzeugung der Leiterbahnen sind druckfähige Pasten, welche elektrisch leitende Metallpartikel und oxidische Komponenten enthalten. Diese können durch Sieb-, Schablonen- und Tampondruck oder durch paste-writing aufgebracht werden. Das derzeit gängigste Verfahren ist der Siebdruck, mit dem Leiterbahnen bis ca. 100 µm Breite erzeugt werden können.

Nachteilig an diesen Verfahren ist jedoch, daß mit schmaler werdenden Leiterbahnen und auch deren Stärke (Höhe) abnimmt und sich dadurch der elektrische Widerstand beträchtlich erhöht.

Verstärkt wird dieser Effekt, durch die enthaltenen Oxidkomponenten, die für die Haftung der Leiterbahnen und Elektrodenstrukturen auf den Substraten erforderlich sind. Einzelne leitfähige Partikel können in der aufgedruckten Leiterbahn elektrisch isoliert sein und so den effektiven Leiterbahnquerschnitt weiter verringern.

Eine Anwendung der Dickfilmmetallisierung findet sich bei der Herstellung von Solarzellen, bei denen die Stromableitung an der Lichteinfallseite über feine Elektrodenstrukturen erfolgt. Um eine möglichst geringe Lichtabschattung aktiver Halbleiterbereiche zu erreichen, geht die Entwicklung zu immer feineren Elektrodenstrukturen.

Speziell bei Solarzellen ist aber bereits bei Leiterbahn- bzw. Elektrodenstrukturen von 100 µm Breite aufgrund der relativ hohen Stromstärke die Stromableitung verbesserungsfähig. Durch den geringen Leiterbahnquerschnitt steigt der Serienwiderstand der Solarzelle, wobei sich Füllfaktor und Wirkungsgrad erniedrigen. Eine Erhöhung des Metallanteils in der Paste ist wegen der sich daraus ergebenden Haftprobleme der Leiterbahnen auf dem Substrat ausgeschlossen.

Aus einem Beitrag von L. Frisson et al in Conf. Rec. 13th IEEE Photovoltaic Specialists Conference, 5. bis 8. Juni 1978, Washington DC, Seiten 590 bis 592, ist ein Verfahren zur Herstellung eines Vorderseitenkontakts einer Solarzelle bekannt. Dabei wird zunächst eine leitfähige Paste auf der Solarzelle aufgedruckt und eingebrannt. Anschließend wird elektrolytisch zunächst eine Kupferschicht und dann eine Zinnschicht abgeschieden, welche schließlich durch Eintauchen in flüssiges Lötzinn mit Lot verstärkt wird.

Aus der DE-A-36 12 085 ist es bekannt, den Rückseitenkontakt einer Solarzelle mittels einer aluminiumhaltigen Paste aufzutragen und einzubrennen und anschließend den Vorderseitenkontakt mit Hilfe einer silberhaltigen Paste aufzudrucken und ebenfalls einzubrennen. Mittels schmelzflüssigem Lot werden die Kontakte verstärkt.

Nachteilig an den bekannten Verfahren ist, daß mit der dort modifizierten Dickfilmtechnik entweder nur grobe Strukturen erzeugt werden können, die zu einer zu starken Abschattung der aktiven Solarzellenoberfläche führen oder daß die erzeugten Elektrodenstrukturen eine zu geringe Haftung auf der Solarzellenoberfläche aufweisen. Auch die unterschiedliche Prozessierung von Vorder- und Rückseitenkontakt führt zu einem hohen Verfahrensaufwand.

Zur weiteren Steigerung der Solarzellenleistung sind Leiterbahnen bzw. Elektrodenstrukturen von weniger als 100 µm Breite erforderlich. Zu deren Erzeugung ist jedoch der Einsatz einer Photo- oder Lasertechnik nötig, die wesentlich aufwendiger und teurer als die besagte einfache Dickfilmtechnik ist.

Aus der Zeitschrift Electronics, Band 53, Nr. 20, 11. September 1980, Seiten 40 bis 41, ist ein kombiniertes Verfahren zur Herstellung von Solarzellenkontakten bekannt. Dabei wird eine aufgedruckte Nickeltinte eingebrannt und galvanisch mit Kupfer verstärkt.

Aufgabe der vorliegenden Erfindung ist es daher, ein Verfahren zum Erzeugen von Leiterbahn- oder Elektrodenstrukturen anzugeben, welches einfach und reproduzierbar durchzuführen ist, und mit dem sich Leiterbahn- und Elektrodenstrukturen von 100 um Breite und weniger herstellen lassen, die gegenüber der bekannten Dickfilmmetallisierung eine verbesserte Leitfähigkeit und eine verbesserte Haftung aufweisen.

Diese Aufgabe wird erfindungsgemäß gelost durch ein Verfahren nach Anspruch 1. Weitere Ausgestaltungen der Erfindung sind den Unteransprüchen zu entnehmen.

Die Erfindung ermöglicht in einfacher Weise eine beliebige Erhöhung des effektiven Leiterbahnquerschnitts und damit eine Reduzierung des effektiven Widerstands der Leiterbahn bzw. der Elektrodenstrukturen. Die Anwendung des erfindungsgemäßen Verfahrens zur Erzeugung von Elektrodenstrukturen bei Solarzellen führt zu einer Erhöhung des Füllfaktors und des Wirkungsgrades der Solarzellen. Weiterhin werden mit dem Verfahren voneinander getrennte und daher elektrisch isolierte Inseln bildende Metallpartikel mit benachbarten Partikeln elektrisch leitend verbunden und können daher zusätzlich zur Stromleitung beitragen.

Die so erzeugten Elektrodenstrukturen besitzen einen ausreichend niedrigen Schichtwiderstand, was bei der Verwendung für Solarzellen zu einem erniedrigten Serienwiderstand führt. Es ist keine weitere Verstärkung der Elektrodenstruktur erforderlich, etwa durch eine weitere elektrolytisch aufgebrachte Elektrodenschicht oder eine Lötzinnbehandlung, wie sie in dem zitierten Artikel von Frisson et al beschrieben ist.

Die Haftfestigkeit der Elektrodenstrukturen auf Solarzellen-Substraten wie Halbleitermaterial ist unverändert gut und erleidet durch den galvanischen Schritt keinerlei Einbußen. Die gute Haftung der Elektrodenstrukturen auf dem Substrat ist überraschend, da bekannte galvanische Bäder gegenüber aufgedruckten und eingebrannten Strukturen chemisch aggressive Medien darstellen. Eine bislang zur Verbesserung der Leitfähigkeit erforderliche naßchemische Nachbehandlunc, beispielsweise mit Flußsäure bei Siliziumsubstraten, wird überflüssig. Die galvanische Verstärkung ist ein leicht zu überwachender Schritt, der gut über Stromstärke und Zeit kontrolliert werden kann. Neben der Aufdickung der Leiterbahn- und Elektrodenstrukturen wird dabei eine leichte Verbreiterung der Strukturen beobachtet.

In dem Verfahren werden Silberpartikel enthaltende druckfähige Pasten eingesetzt. Oxidische Zumischungen und dafür erforderliche Einbrenntemperaturen sind jedoch üblicherweise auf das verwendete Substrat abgestimmt.

Zum Aufbringen der Paste wird ein Siebdruckverfahren beda es einfach durchzuführen ist und gute Druckergebnisse zeigt.

Für das Metallisierungsbad werden von anderen galvanischen Anwendungen bekannte Bäder verwendet.

Kurze Galvanisierzeiten benötigt zum Beispiel ein cyanidisches Silberbad bei einer Stromdichte von 0,5 bis 1,5 A/dm². Dieses Bad bringt gute Ergebnisse, erfordert aber eine genaue Prozeßkontrolle, um Haftungsprobleme der verdickten Elektrodenstruktur nach der Behandlung im sauren bzw. cyanidisch alkalischen Bad zu vermeiden. Vorteilhafterweise werden daher neutrale bzw. schwach alkalische Metallisierungsbäder zur Durchführung des erfindungsgemäßen Verfahrens verwendet. Diese verhalten sich weitgehend chemisch inert gegenüber dem anorganischen Binder der eingebrannten Siebdruckpaste, so daß sie deren Haftung auf dem Substrat nicht beeinflussen und daher eine stabile Haftung der nach dem galvanischen Aufdicken fertigen Elektrodenstrukturen gewährleisten. Gute Ergebnisse werden zum Beispiel mit einem für die Galvanik unüblichen Metallisierungsbad erzielt, welches eine Silbersalzlösung auf der Basis von Thiosulfat enthält. Dafür erforderliche Stromdichten werden zwischen 0,2 und 1,0 A/dm² gewählt. Das Silber/Thiosulfat-Bad ist für die Galvanik unüblich, da es nicht stabil ist. Unerwarteterweise kann ein solches Bad jedoch bei regelmäßiger Abfiltration von anfallendem Silbersulfid, möglichst kühler Aufbewahrung und Anwendung bei niedrigen Temperaturen bis zu einem Jahr verwendet werden.

In einer Anwendung des Verfahrens zur Herstellung der Vorderseitenelektrodenstrukturen von kristallinen und polykristallinen Solarzellen aus Silizium werden bei Expositionszeiten im galvanischen Metallisierungsbad ab 2 Minuten (cyanidisches Silberbad) bis ca. 20 Minuten (Silberbad auf der Basis von Thiosulfat) deutliche Verbesserungen der I-U Kennlinie durch Verringerung des Serienwiderstandes und damit eine Erhöhung des Füllfaktors und des-Wirkungsgrades beobachtet.

Eine besonders gleichmäßige Verstärkung der Elektrodenstrukturen wird erzielt, wenn für den galvanischen Prozeß pulsierender Gleichstrom (pulse-plating) verwendet wird.

Im folgenden wird die Erfindung anhand von Ausführungsbeispielen und der dazugehörigen drei Figuren näher erläutert.
- Figur 1: zeigt die Vorderseite einer Solarzelle, deren Elektrodenstruktur gemäß dem erfindungsgemäßen Verfahren hergestellt wird,
- Figur 2: zeigt in einer REM-Aufnahme den Schnitt durch eine erfindungsgemäß hergestellte Leiterbahn und
- Figur 3: zeigt die Strom-Spannungskennlinien einer Solarzelle mit erfindungsgemäß hergestellter Elektrodenstruktur im Vergleich zu herkömmlich erzeugten.

### Ausführungsbeispiele:

In einer Anwendung der Erfindung werden Elektrodenstrukturen auf der Vorderseite und der Rückseite von Solarzellen erzeugt. Für die Versuchsreihen werden Solarzellen aus monokristallinen ≺100≻ Cz-Siliziumscheiben vom p-Typ verwendet, die in bekannter Weise gefertigt und vorbereitet wurden. Die Oberfläche der Solarzellen wird durch eine Textur-Ätzung behandelt, der Halbleiterübergang ist durch Phosphor- Diffusion erzeugt und für einen Teil der Versuche (V₂, V₃) wird die Oberfläche der Solarzellen durch Oxidation passiviert.

Nun wird eine silberhaltige Paste, die als anorganischen Binder Bleioxid und Siliziumoxid enthält, in einem Siebdruckverfahren gemäß dem gewünschten Muster der späteren Elektrodenstrukturen aufgedruckt. Die Paste kann zusätzlich ein Element der Gruppe Va des Periodensystems zum Beispiel Antiomon enthalten, muß aber nicht. Parallel mit dem Aufdruck des Musters für den Vorderseitenkontakt kann auch ein gewünschter gegebenenfalls gemusterter oder ganzflächiger Rückseitenkontakt aufgedruckt werden. Dazu wird ebenfalls eine zum Beispiel Silberpartikel enthaltende Druckpaste verwendet, die außerdem zur p⁺ Dotierung und zur Erzielung eines Ohm'schen Kontaktes ca. 1 bis 3 Prozent Aluminium enthält. Das Einbrennen von aufgedrucktem Vorder- und Rückseitenkontakt kann erfindungsgemäß zusammen erfolgen (sog. Co-firing), so daß im Gegensatz zu bekannten Verfahren kein zusätzlicher Ofenprozeß zum Einbrennen mehr erforderlich ist. Das Einbrennen des Musters erfolgt zwischen 700 und 930°C, beispielsweise bei 800°C. Vorhandenes Siliziumoxid, zum Beispiel eine Passivierungs- oder eine Antireflexschicht, wird dabei sowohl auf der Vorder- als auch auf der Rückseite durchgebrannt.

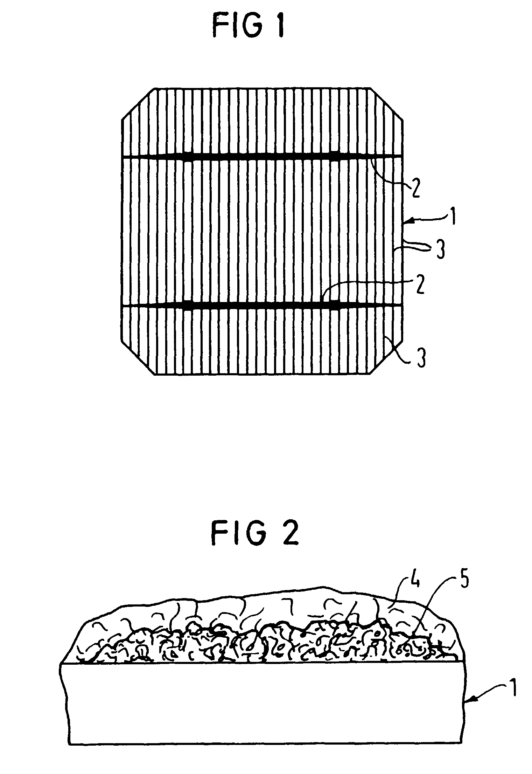

Figur 1 zeigt das auf der Solarzelle 1 erzeugte Muster, welches aus breiten Busstrukturen 2 und feineren Leiterbahnen 3 (Elektrodenfinger) besteht. Die zuletzt genannten Strukturen weisen beispielsweise eine Breite von 110 µm auf, wobei die Dicke der aufgedruckten Strukturen ursprünglich 7 µm betrug.

Zur galvanischen Verstärkung des aufgedruckten Musters wird ein silberhaltiges galvanisches Bad vorbereitet. Das neutrale Bad enthält pro Liter wäßrig neutraler Lösung 20 bis 30 g Silberchlorid und 200 bis 300 g Natriumthiosulfat Na₂S₂O₃.5H₂O.

Die Solarzellen 1 werden zunächst elektrisch kontaktiert, wobei ein Kontakt an jeder Busstruktur 2 ausreichend ist. Wahlweise kann auch die auf der Rückseite aufgedruckte Struktur kontaktiert werden. Dies ist jedoch nicht unbedingt erforderlich, da auf der Solarzellenrückseite keine Abschattung zu beachten ist und die gegebenenfalls gemusterte Elektrodenstruktur dicker oder als ganzflächige Schicht aufgebracht werden kann, so daß die Rückseitenelektrode bereits nach dem Einbrennen einen ausreichend niedrigen Schichtwiderstand aufweist. Dann werden die Solarzellen in Halterungen fixiert in das Metallisierungsbad gehängt. Die Abscheidung im Bad a erfolgt bei einer Stromdichte von 0,5 bis 1,5 A/dm² während zwei bis sechs Minuten bei Raumtemperatur. Für Bad b wird eine Stromdichte von 0,2 bis 1,0 A/dm² für 10 bis 20 Minuten ebenfalls bei Raumtemperatur gewählt.

Die galvanische Verstärkung hat eine deutliche Aufdickung des gedruckten Musters zur Folge, deren Dicke um 1 bis 5 µm erhöht ist. Ebenso wird eine leichte Verbreiterung der Strukturen 3 der Vorderseitenelektrode von 110 auf 140 µm beobachtet. Diese Verstärkung des Musters hat zunächst eine Erniedrigung des Widerstands der Elektrodenstruktur zur Folge, wobei der zwischen den beiden Bussen 2 gemessene Widerstand von ursprünglich 100 bis 150 mOhm auf 20 bis 30 m-Ohm absinkt. Dies entspricht einer Erniedrigung des Schichtwiderstands von ursprünglich 5 bis 10 mOhm per Square auf 1 bis 5 mOhm per Square. In allen Fällen jedoch wird eine Verringerung des gemessenen Widerstands um mindestens Faktor 3 beobachtet.

Figur 2 zeigt einen entsprechend einer röntgenmikroskopischen Aufnahme (REM) gezeichneten Querschnitt durch eine der so erzeugten Leiterbahnen 3. Gut erkennbar ist die gleichmäßige Struktur, die gute Verbindung der aufgedickten oberen Teile 4 zu den aufgedruckten Teilen 5 und die saubere Oberfläche. Weiterhin zeigt sich eine gute Haftung der Elektrodenstrukturen, die durch das galvanische Metallisierungsbad keinerlei Einbußen erleidet.

Für den Versuch V3 wird ein Teil der Solarzellen mit einer aus Titanoxid TiOₓ bestehenden Antireflexbeschichtung (AR) versehen. Gegebenenfalls können die erfindungsgemäß erzeugten Elektrodenstrukturen bzw. die Solarzellen noch einer Temperaturbehandlung unterzogen werden, zum Beispiel 24 Stunden bei 130°C, oder 20 bis 30 Minuten bei 200 bis 300°C.

Für sämtliche Solarzellen werden die Strom-Spannungs-Kennlinien gemessen und außerdem der Füllfaktor FF und der Wirkungsgrad η bestimmt. Aus den gemessenen Werten der Versuche V1, V2 und V3 werden die Mittelwerte bestimmt und in der folgenden Tabelle aufgelistet. Es sind jeweils zwei Werte aufgelistet, wobei der erste an Solarzellen gemessen wurde, deren Elektrodenstrukturen herkömmlich ohne galvanische Verstärkung erzeugt wurden. Der zweite Wert entspricht den erfindungsgemäß behandelten Solarzellen bzw. den Solarzellen mit den erfindungsgemäß erzeugten Elektrodenstrukturen.

| | V1 ohne Passivierung | V2 mit Passivierung | V3 mit Passivierung + AR |
|---|---|---|---|
| FF | 74,1 - 77,0 | 71,5 - 76,2 | 72,1 - 76,0 |
| η | 12,8 - 13,3 | 14,2 - 15,0 | 14,9 - 15,9 |

Als Resultat des erfindungsgemäßen Verfahrens ist somit bei allen Solarzellen eine Verbesserung des Füllfaktors zu erkennen, die einer Erhöhung des gemessenen Wirkungsgrades bis zu einem Prozentpunkt resultiert. Mit dem erfindungsgemäßen Verfahren können somit wesentlich verbesserte Solarzellen hergestellt werden.

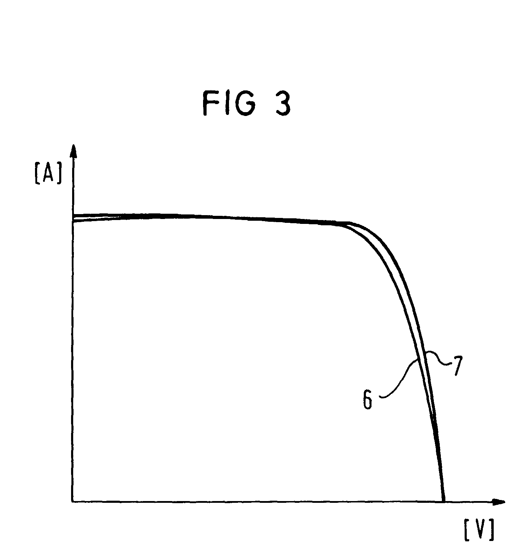

Figur 3 zeigt die Kennlinien von Solarzellen mit herkömmlichen Elektrodenstrukturen (6) und mit erfindungsgemäß erzeugten Solarzellen Strukturen (7). Erwartungsgemäß sind die Eckwerte Iₖ und Uₒ im wesentlichen unverändert. Die Verbesserung zeigt sich vielmehr im Verlauf der Kurve, der den Füllfaktor bestimmt.

Aus den bereits erwähnten Gründen erbringt das erfindungsgemäße Verfahren bei Solarzellen besondere Vorteile und kann dort auch zur Verstärkung der Rückseitenmetallisierung eingesetzt werden.

Die Anpassung an unterschiedliche Substrate kann über die Zusammensetzung der Paste erfolgen, insbesondere durch Zumischung geeigneter oxidischer Komponenten zur Erhöhung der Haftfestigkeit, die im Ausführungsbeispiel für Silizium und Siliziumoxid bereits nachgewiesen wurde.

## Patentansprüche

1. Verfahren zum Erzeugen feiner Elektrodenstruktur für Solarzellen mit den Schritten
- Aufbringen einer Silberpartikel als leitfähige Partikel enthaltenden Paste entsprechend einem vorgegebenen Muster auf einem Solarzellen-Substrat,
- Einbrennen des Musters bei erhöhter Temperatur und
- galvanische Verstärkung des Musters bei Raumtemperatur in einem neutralen Metallisierungsbad auf der Basis von Thiosulfat und einem Silbersalz oder in einem cyanidischen Silberbad, wobei die Elektrodenstrukturen erhalten werden.

2. Verfahren nach Anspruch 1,
bei dem eine Silberpartikel enthaltende Paste mit anorganischem Binder verwendet wird.

3. Verfahren nach einem der Ansprüche 1 oder 2,
bei dem das Muster durch ein Sieb-, Tampon- oder Schablonendruckverfahren aufgebracht wird.

4. Verfahren nach einem der Ansprüche 1 bis 3,
bei dem die galvanische Verstärkung mittels pulsierendem Gleichstrom durchgeführt wird.

5. Verfahren nach einem der Ansprüche 1 bis 4, mit den weiteren Merkmalen:
- ein vorgegebenes feines Muster wird auf der Vorderseite des Solarzellensubstrates aufgebracht
- auf der Rückseite des Solarzellensubstrats wird eine gegebenenfalls gemusterte Schicht einer leitfähige Silberpartikel enthaltenden Paste aufgebracht, welche außerdem ca. 1 bis 3 Prozent Aluminium enthält.
- das Muster auf der Vorderseite und die Schicht auf der Rückseite des Solarzellensubstrats werden gleichzeitig eingebrannt und
- anschließend wird die galvanische Verstärkung des Musters auf der Vorderseite und der Schicht auf der Rückseite des Substrats in einem silberhaltigen neutralen oder cynidischen Metallisierungsbad durchgeführt.

6. Verfahren nach Anspruch 5,
bei dem das gemeinsame Einbrennen des Musters auf der Vorderseite und der Schicht auf der Rückseite des Substrats bei 700 bis 900°C, vorzugsweise bei ca. 800°C durchgeführt wird.

## Claims

1. Process for producing fine electrode a structure for solar cells, with the steps of:
- applying a paste, containing silver particles as conductive particles, according to a predetermined pattern on a solar cell substrate,
- firing the pattern at elevated temperature, and
- electrolytic enhancement of the pattern at room temperature in a neutral plating bath based on thiosulphate and a silver salt, or in a cyanide silver bath, the electrode structures being obtained.

2. Process according to Claim 1, in which a paste containing silver particles is used with inorganic binder.

3. Process according to one of Claims 1 or 2, in which the pattern is applied by a screen, pad or stencil printing process.

4. Process according to one of Claims 1 to 3, in which the electrolytic enhancement is carried out using pulsed direct current.

5. Process according to one of Claims 1 to 4, with the further features:
- a predetermined fine pattern is applied on the front of the solar cell substrate
- an optionally patterned layer of a paste, containing conductive silver particles, which furthermore contains approximately 1 to 3 per cent of aluminium, is applied on the back of the solar cell substrate
- the pattern on the front and the layer on the back of the solar cell substrate are simultaneously fired, and
- the electrolytic enhancement of the pattern on the front and of the layer on the back of the substrate is then carried out in a silver-containing neutral or cyanide plating bath.

6. Process according to Claim 5, in which the cofiring of the pattern on the front and of the layer on the back of the substrate is carried out at 700 to 900°C, preferably at approximately 800°C.

## Revendications

1. Procédé pour produire une structure fine d'électrode destinée à des piles solaires, comportant les étapes
- on dépose une pâte contenant des particules d'argent comme particules conductrices sur un substrat de pile solaire, suivant un modèle prescrit,
- on cuit le modèle à une température élevée et
- on renforce par galvanisation le modèle à la température ambiante, dans un bain de métallisation neutre à base d'hyposulfite et d'un sel d'argent ou dans un bain d'argent cyanuré, les structures d'électrodes étant obtenues.

2. Procédé suivant la revendication 1, dans lequel on utilise un pâte contenant des particules d'argent et comportant un liant minéral.

3. Procédé suivant une des revendications 1 ou 2, dans lequel on dépose le modèle dans un procédé de sérigraphie, de tamponnage ou de pochage.

4. procédé suivant une des revendications 1 à 3, dans lequel on met en oeuvre le renforcement galvanique au moyen d'un courant continu pulsé.

5. Procédé suivant une des revendications 1 à 4, ayant les caractéristiques supplémentaires:
- on dépose un modèle fin prescrit sur la face avant du substrat de pile solaire
- on dépose sur la face arrière du substrat de pile solaire une couche éventuellement modélisée d'une pâte qui contient des particules d'argent conductrices et qui contient en outre environ 1 à 3 pour-cent d'aluminium
- on cuit en même temps le modèle présent sur la face avant et la couche déposée sur la face arrière du substrat de pile solaire, et
- ensuite, on effectue le renforcement galvanique du modèle déposé sur la face avant et de la couche déposée sur la face arrière du substrat dans un bain de métallisation neutre à teneur en argent, neutre ou cyanuré.

6. Procédé suivant la revendication 5, dans lequel on effectue la cuisson commune du modèle déposé sur la face avant et de la couche déposée sur la face arrière du substrat à 700 à 900° C, de préférence à environ 800° C.
